# EUROPEAN PATENT APPLICATION

(11) **EP 1 808 514 A1**
(43) Date of publication of application: **18.07.2007**
(21) Application number: 05772788.5
(22) Date of filing: 18.08.2005
(51) Int. Cl.: C30B 29/06, C30B 15/00

(54) **SINGLE-CRYSTAL PRODUCTION APPARATUS**

(30) Priority: 13.10.2004 JP 2004298885
(71) Applicant: SHIN-ETSU HANDOTAI COMPANY LIMITED, Chiyoda-ku Tokyo 100-0005 (JP)
(72) Inventor: SAKURADA, Masahiro, c/o Shirakawa R&D Center, Nishigo-mura Nishishirakawa-gun, Fukushima (JP)
(74) Representative: Wibbelmann, Jobst
(86) International application number: PCT/JP2005/015074
(87) International publication number: WO 2006/040878

(57) **Abstract**

The present invention is an apparatus for producing a single crystal by which a silicon single crystal is grown by Czochralski method, comprising, at least, a gas flow-guide cylinder which is disposed so as to surround the silicon single crystal in a chamber for growing the single crystal in order to straighten flow of a gas introduced into the chamber, and a quartz member containing bubbles that is provided inside the gas flow-guide cylinder. Thereby, there can be provided a single crystal-producing apparatus by which when a CZ silicon single crystal is grown, a silicon single crystal having a desired defect region being uniform in a plane can be effectively produced by controlling F/G along the radial direction in the single crystal plane constantly to be a predetermined value, and further contamination with impurities of Fe and Cu is prevented, and thereby a silicon single crystal of high quality can be produced.

## Description

### Technical Field

The present invention relates to an apparatus for producing a single crystal by which a silicon single crystal is grown by Czochralski method (hereinafter, called as CZ method), more specifically to an apparatus for producing a single crystal by which when a single crystal is pulled, the temperature gradient in the vicinity of the solid-liquid interface along the direction of the crystal growth axis can be controlled to be uniform in the radial direction of the silicon single crystal, and thereby a silicon single crystal having a desired defect region being distributed uniformly in a plane can be effectively produced, and a silicon single crystal of high quality can be produced so that contamination due to impurity metal elements is small.

### Background Art

As a single crystal used as a substrate of a semiconductor device, for example, there is a silicon single crystal, and it is mainly produced by CZ method. In recent years, semiconductors have become higher integrated and finer, and therewith, the problem of Grown-in defects introduced in the growth of a silicon single crystal has become important.

In the Grown-in defects, there are, vacancy type defects originated from voids such as FPD (Flow Pattern Defect) and COP (Crystal Originated Particle) which are formed when a crystal growth rate (crystal pulling rate) F is relatively high, OSF (Oxidation Induced Stacking Fault) generated when the pulling rate is lower, defects of a agglomerated interstitial silicones being thought to be originated from dislocation loops such as LSEP (Large Secco Etching Pit) and LFPD (Large Flow Pattern Defect) which are generated when the pulling rate is further lower.

In recent years, there has been discovered N (Neutral) region in which neither vacancy type defects originated from voids nor interstitial silicon type defects originated from dislocation loops exist outside an OSF ring between V (Vacancy) region in which FPD or COP exists and I (Interstitial) region in which LSEP or LFPD exists. When this region is further categorized, there are Nv region having many vacancies and Ni region having many interstitial silicones. It has been found that when a thermal oxidation treatment is performed, amount of precipitated oxygen in Nv region is larger, and very little oxygen is precipitated in Ni region.

Furthermore, it has been found that a region in which defects detected by Cu deposition treatment exist in some part of Nv region generating easily oxygen precipitation after a thermal oxidation treatment exist.

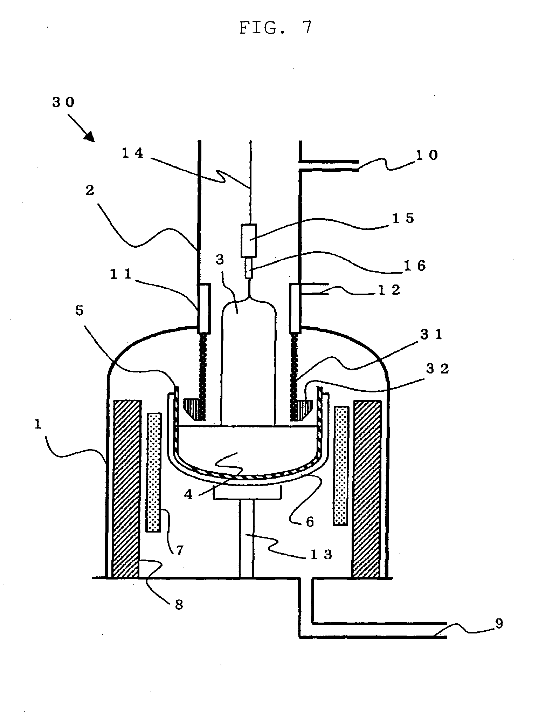

Generally, when the silicon single crystal is produced by CZ method, for example, an apparatus for producing a single crystal as shown in Fig. 7 is used.

This apparatus 30 for producing a single crystal has a main chamber 1 storing a crucible for containing a raw material polycrystal such as silicon, a heating heater, and a heat insulating member for insulating radiant heat, and so on. In an upper part of this main chamber 1, a pulling chamber 2 for containing and taking out a grown single crystal 3 is connected, and in the upper part, a pulling mechanism (not shown) for pulling the single crystal 3 with a wire 14 is provided.

In the main chamber 1, a quartz crucible 5 for containing a melted raw material melt 4 and a graphite crucible 6 for supporting the quartz crucible 5 are provided, and these crucibles 5, 6 are supported with a support axis 13 so as to be capable of rotating, rising, and falling by a driving mechanism (not shown). The driving mechanism for these crucibles 5, 6 raises the crucibles 5, 6 by the amount of the liquid level lowering so as to compensate the lowering of the liquid level of the raw material melt 4 along with pulling of the single crystal 3.

And, a heating heater 7 having a cylindrical shape is disposed so as to surround the crucibles 5, 6. Outside this heating heater 7, a heat insulating member 8 is provided so as to surround the circumstance thereof in order that heat from the heating heater 7 is prevented from being radiated directly to the main chamber 1.

Moreover, inside the main chamber 1, the gas flow-guide cylinder 31 is provided, and at the lower end of the gas flow-guide cylinder 31, heat shielding member 32 is placed, and thereby the radiation from the surface of the raw material melt 4 is cut and the surface of the raw material melt 4 is heat-retained. Furthermore, above the gas flow-guide cylinder 31, a cooling cylinder 11 is placed and the single crystal 3 can be forced to be cooled by flowing a cooling medium from a refrigerant inlet duct 12.

In the case in which a silicon single crystal is grown by CZ method by using such a apparatus 30 for producing a single crystal, first, polycrystalline silicon to be a raw material is contained in the quartz crucible 5, and the polycrystalline silicon in the quartz crucible 5 is heated and melted by the heating heater 7. Next, along with introducing an inert gas such as Ar from a gas inlet duct 10 provided at an upper part of the pulling chamber 2, a seed crystal 16 fixed in a seed holder 15 is immersed in the raw material melt 4, and then calmly pulled with being rotated, and thereby a silicon single crystal 3 having an approximately column shape can be grown. In this case, the inert gas introduced from the gas inlet duct 10 can be passed between the gas flow-guide cylinder 31 and the silicon single crystal 3 being pulled and can be discharged from a gas outlet duct 9.

In such production of single crystal by CZ method, with respect to the above-described Grown-in defects, it is thought that the introduced amount thereof is determined by the parameter of F/G (mm²/°C·min), which is a ratio of pulling rate F (mm/min) when the single crystal is grown, and crystal temperature gradient G (°C/mm) along the pulling axis direction between the melting point of silicon and 1400°C in the vicinity of the solid-liquid interface (see, for example, V. V. Voronkov, Journal of Crystal Growth, vol. 59 (1982), pp. 625-643).

Generally, with respect to the temperature gradient along the crystal growth axis direction, thermal environment in the CZ furnace is gradually changed along the change of the crystal length, residual melt amount, and so forth, and therefore, in the growth of the single crystal, along with the growth of the single crystal, the temperature gradient G along the crystal growth direction becomes gradually changed. Therefore, for example, by controlling the pulling rate F along with the growth of the single crystal according to the change of the temperature gradient G so that F/G is constant, it becomes possible to pull a silicon single crystal having a desired defect region or a desired defect-free region, over the entire region of the straight body of the single crystal (see, Japanese Patent Application (Kokai) No. 8-330316).

However, in the case in which a single crystal having N region is pulled by controlling the pulling rate, for example, OSF region and N region, or V region and N region, or I region and N region, are occasionally mixed in a single crystal plane. If V region, OSF region, or I region exists in the wafer plane as well as N region, there is a danger of triggering significant degradation of electric characteristics. Therefore, improvement of uniformity of defect quality in the wafer plane has been a problem.

As a method for uniformly controlling the defect distribution in the wafer plane, for example, there has been proposed a method for enlarging the distance from the melt surface to the lower end of the gas flow-guide cylinder. However, if the distance from the melt surface to the lower end of the gas flow-guide cylinder is excessively enlarged, the effects by straightening flow of the inert gas, such as lowering of, the control of the oxygen concentration in the crystal and the pulling rate for a N region crystal, are caused. Therefore, it has been required that the silicon single crystal is grown without enlarging the distance from the melt surface to the lower end of the gas flow-guide cylinder.

On the other hand, as an important factor for improving yield in the device production in recent years, yield improvement of the devices in the peripheral portion of the wafer has become a problem. Therefore, in the wafer peripheral portion, it has become important to reduce heavy metals such as iron (Fe) and copper (Cu). As a cause of such heavy metal contamination caused in a single crystal, it is known that Fe and Cu elements are mixed in the raw material melt from the raw material and the constitutive parts in the furnace, and taken in the silicon single crystal from the solid-liquid interface. However, recently, it has been revealed that Fe, Cu, or the like, for example, released from the gas flow-guide cylinder attaches to the single crystal in the growth, and diffuses inside, and thereby contamination with impurities of heavy metals and so forth is caused in the crystal peripheral portion.

In the case in which a silicon single crystal with a large diameter having a diameter of 200 mm or more is grown by CZ method, a single crystal-producing apparatus in which a gas flow-guide cylinder is placed so as to surround the single crystal pulled from the raw material melt is occasionally utilized. This gas flow-guide cylinder is important for straightening the inert gas supplied in the chamber in the growth and effectively discharging silicon oxide evaporating from the raw material melt to the outside of the furnace.

Generally, as such a gas flow-guide cylinder, a carbon member such as graphite member is used, and placed so as to be approximated to the crystal by the distance in the range of 10 to 200 mm, particularly, 10 to 100 mm. Moreover, as the material of the gas flow-guide cylinder, a high melting point metal such as tungsten or molybdenum is occasionally used. Furthermore, when an appropriate refrigerant is used, stainless steel or copper can also be used as the material of the gas flow-guide cylinder.

Furthermore, for insulating radiation from the heating heater or the raw material melt and enhancing heat-retaining property in the gas flow-guide cylinder, a heat insulating material made of carbon felt inside the gas flow-guide cylinder.

However, if heavy metal components such as Fe and Cu are released from the gas flow-guide cylinder when a silicon single crystal is grown, these heavy metal components attach to the single crystal surface in the growth, and diffusion of Fe and Cu is caused from the crystal periphery in the subsequent process of being cooled down from a high temperature to a room temperature, and metal contamination becomes caused in the peripheral portion of the single crystal, particularly, in the peripheral portion within 10% of the diameter from the periphery of the single crystal. Among them, there is a problem that a heat insulating material made of carbon felt has lower purity than that of a graphite member or the like, and additionally, fibers are easily scattered in the growth of the silicon single crystal, and thereby contamination due to Fe, Cu, or the like, is easily caused.

### Disclosure of the Invention

The present invention has been made to solve the above problems. A main object of the present invention is to provide a single crystal-producing apparatus by which when a CZ silicon single crystal is grown, a silicon single crystal having a desired defect region being uniform in a plane can be effectively produced by controlling F/G along the radial direction in the single crystal plane constantly to be a predetermined value, and further contamination with impurities of Fe and Cu is prevented, and thereby a silicon single crystal of high quality can be produced.

To achieve the above object, the present invention provides an apparatus for producing a single crystal by which a silicon single crystal is grown by Czochralski method, comprising, at least, a gas flow-guide cylinder which is disposed so as to surround the silicon single crystal in a chamber for growing the single crystal in order to straighten flow of a gas introduced into the chamber, and a quartz member containing bubbles that is provided inside the gas flow-guide cylinder.

By the apparatus for producing a single crystal in which a quartz member containing bubbles that is provided inside the gas flow-guide cylinder disposed so that the cylinder surrounds the silicon single crystal in the chamber as described above, it can be a single crystal-producing apparatus by which when the silicon single crystal is grown, radiant heat from the heater for heating the silicon melt or the silicon melt can be insulated and heat-retaining property in the gas flow-guide cylinder can be enhanced. Thereby, it becomes a single crystal-producing apparatus by which the crystal temperature gradient G along the pulling axis direction in the vicinity of the solid-liquid interface in the pulling of the single crystal becomes possible to be controlled uniformly in the radial direction of the single crystal and a silicon single crystal in which a desired defect region, particularly, defect-free region is distributed uniformly in a plane can be effectively produced by controlling F/G constantly to be a predetermined value in the radial direction. Furthermore, because the quartz member containing bubbles that is provided inside the gas flow-guide cylinder, it can be an apparatus by which the contamination with impurities of Fe and Cu from the gas flow-guide cylinder is effectively prevented and thereby silicon single crystals of high quality can be stably produced.

In the above case, it is preferable that a density of the bubbles in the quartz member containing bubbles that is provided inside the gas flow-guide cylinder is in a range of 5 × 10⁴ number/cm³ 3 to 1 × 10⁶ number/cm³.

If a density of the bubbles in the quartz member containing bubbles that is provided inside the gas flow-guide cylinder is in the range of 5 × 10⁴ number/cm³ to 1 × 10⁶ number/cm³ as described above, when the silicon single crystal is grown, radiant heat from the heater for heating the silicon melt or the silicon melt can be more effectively insulated and heat-retaining property in the gas flow-guide cylinder can be further improved. Thereby, with a high pulling rate F, F/G can be controlled constantly to be a predetermined value, it becomes possible to produce a silicon single crystal in which a desired defect region is distributed uniformly in a plane and particularly, the permissible width for controlling the pulling rate being capable of producing a silicon single crystal having a defect-free region becomes enlarged, and therefore, it becomes a single crystal-producing apparatus by which silicon single crystals each having a defect-free region can be stably produced.

In the above case, it is preferable that the quartz member containing bubbles that is provided inside the gas flow-guide cylinder has an occupied rate of 20% or more with respect to a surface area inside the gas flow-guide cylinder, and has a wall thickness of 3 mm to 50 mm.

When the quartz member containing bubbles that is provided inside the gas flow-guide cylinder has an occupied rate of 20% or more with respect to a surface area inside the gas flow-guide cylinder, and has a wall thickness of 3 mm to 50 mm as described above, it becomes a single crystal-producing apparatus by which radiant heat from the heating heater or the silicon melt can be more effectively insulated and heat-retaining property in the gas flow-guide cylinder can be further improved.

In the above case, it is preferable that the quartz member containing bubbles that is provided inside the gas flow-guide cylinder has a logarithmic viscosity of 10 poise to 14 poise in 1250°C.

When the quartz member containing bubbles that is provided inside the gas flow-guide cylinder has a logarithmic viscosity of 10 poise to 14 poise in 1250°C as described above, it becomes possible that the quartz member is certainly prevented from being exposed to the high temperature and softened and deformed in the growth of the silicon single crystal.

In the above case, it is preferable that in the quartz member containing bubbles that is provided inside the gas flow-guide cylinder, an average impurity concentration of Fe and Cu in a surface layer region from a surface of the quartz member to a depth of 10 µm is less than 1 ppm, and an average impurity concentration of Fe and Cu in a region of a depth of more than 10 µm from the surface of the quartz member is lower than that of the surface layer region.

When the quartz member containing bubbles that is provided inside the gas flow-guide cylinder has the average impurity concentrations of Fe and Cu in the above-described ranges, it becomes a single crystal-producing apparatus by which the grown single crystal can be certainly prevented from being contaminated with impurities of Fe and Cu.

Furthermore, the present invention provides a method for producing a single crystal, comprising growing a silicon single crystal by using the above-described apparatus for producing a single crystal.

By growing a silicon single crystal by using the apparatus for producing a single crystal according to the present invention, when the silicon single crystal is grown, radiant heat from the heating heater or the silicon melt can be insulated and heat-retaining property in the gas flow-guide cylinder can be enhanced. Therefore, the crystal temperature gradient G along the pulling axis direction in the vicinity of the solid-liquid interface in the pulling of the single crystal becomes possible to be controlled to be uniform along the radial direction of the single crystal, and a silicon single crystal can be pulled by controlling F/G constantly to be a predetermined value. Therefore, a silicon single crystal in which a desired defect region, particularly, defect-free region is distributed uniformly in a plane can be effectively produced. Moreover, because the quartz member containing bubbles is provided inside the gas flow-guide cylinder, the contamination with impurities of Fe and Cu from the gas flow-guide cylinder is effectively prevented and silicon single crystals of high quality can be produced with high yield.

As described above, according to the present invention, by providing the quartz member containing bubbles inside the gas flow-guide cylinder, it becomes a single crystal-producing apparatus by which radiation from a heating heater or a silicon melt can be insulated and heat-retaining property in the gas flow-guide cylinder can be enhanced. Such an apparatus becomes possible to control the crystal temperature gradient G along the pulling axis direction in the vicinity of the solid-liquid interface in the pulling of the single crystal to be uniform along the radial direction, and to effectively produce a silicon single crystal in which a desired defect region, particularly, defect-free region is distributed uniformly in a plane by controlling F/G constantly to be a predetermined value. Moreover, it becomes a single crystal-producing apparatus by which the contamination with impurities of Fe and Cu from the gas flow-guide cylinder can be effectively prevented, and therefore, silicon single crystals of high quality can be stably produced.

### Brief Explanation of the Drawings

Fig. 1 is a schematic view showing an example of the apparatus for producing a single crystal of the present invention.
Fig. 2 is a view showing a magnified cross-section of a lower part of the gas flow-guide cylinder of another example of the apparatus for producing a single crystal of present invention.
Fig. 3 is a view showing the relation between a length along the crystal growth axis direction of the straight body of a single crystal and a crystal pulling rate, when each of the silicon single crystals of Examples 1 and 2 and Comparative examples 1 and 2 are grown.
Fig. 4 is a view showing the relation between a pulling rate and a crystal defect distribution, in each of the single crystals of Examples 1 and 2.
Fig. 5 is a view showing each of the relations between the pulling rates and the crystal defect distributions, in each of the single crystals of Comparative examples 1 and 2.
Fig. 6 is a diagram showing the result of measuring the average Fe concentration in the peripheral portion of each of sample wafers produced in Examples 1 and 2 and Comparative examples 1 and 2.
Fig. 7 is a schematic view showing an example of a conventional apparatus for producing a single crystal.

### Best Mode for Carrying out the Invention

Hereinafter, embodiments of the present invention will be explained specifically. However, the present invention is not limited thereto.

In order to effectively and stably produce, by CZ method, silicon single crystals of high quality each having a desired defect region, particularly, N region to be uniform in a plane, the present inventor has focused attention on an internal structure of a gas flow-guide cylinder of the apparatus for producing a single crystal. And, it has been found that by providing the quartz member containing bubbles inside the gas flow-guide cylinder, radiation from the heating heater or the silicon melt can be insulated and heat-retaining property in the gas flow-guide cylinder can be enhanced, and thereby, the crystal temperature gradient G along the pulling axis direction in the vicinity of the solid-liquid interface in the pulling of the single crystal can be controlled to be uniform along the radial direction of the single crystal, and a silicon single crystal having a desired defect region being uniform in a plane can be effectively produced by controlling F/G constantly to be a predetermined value, and furthermore the contamination with impurities of Fe and Cu from the gas flow-guide cylinder is effectively prevented and therefore silicon single crystals of high quality can be stably produced. The present invention has been accomplished.

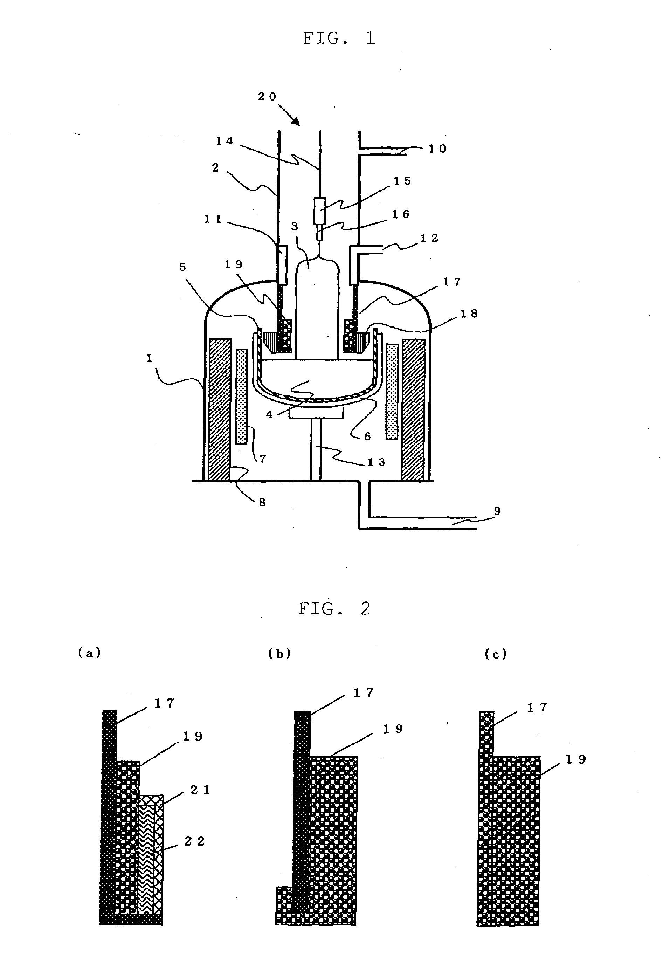

Fig. 1 is a schematic view showing an example of the apparatus for producing a single crystal of the present invention.

In an apparatus 20 for producing a single crystal according to the present invention, for example, a quartz crucible 5 for containing a raw material melt 4 and a graphite crucible 6 for protecting the quartz crucible 5 are supported with a support axis 13 so as to be capable of rotating, rising, and falling by a crucible driving mechanism (not shown), in a main chamber 1. Moreover, above these crucibles 5, 6, a pulling chamber 2 for containing and taking out a grown silicon single crystal 3 is connected, and above the pulling chamber 2, a pulling mechanism (not shown) for pulling the silicon single crystal 3 with being rotated by a wire 14 is provided.

Moreover, a gas flow-guide cylinder 17 made of graphite is disposed so as to surround the silicon single crystal 3 to be grown inside the main chamber 1, and thereby flow of the gas introduced in the chamber can be straightened. Moreover, in order that radiation from the surface of raw material melt 4 is cut and the surface of the raw material melt 4 is heat-retained, a heat shielding member 18 is provided at a lower end outside the gas flow-guide cylinder 17. As the heat shielding member 18, for example, graphite, molybdenum, tungsten, silicon carbide, or graphite coated with silicon carbide on the surface thereof, can be used. And, shape or size thereof is not particularly limited thereto, and can be appropriately modified according to need. Furthermore, above the gas flow-guide cylinder 17, a cooling cylinder 11 having a different material from that of the gas flow-guide cylinder is provided, and thereby the silicon single crystal 3 can be forced to be cooled by flowing a cooling medium from a refrigerant inlet duct 12. In addition, the cooling cylinder 11 is not necessarily placed and can be omitted according to purpose, and the forced cooling of the single crystal may be performed by, for example, passing a cooling medium through the gas flow-guide cylinder.

Furthermore, from a gas inlet duct 10 provided at an upper part of the pulling chamber 2, an inert gas such as Ar can be introduced. It is possible that flow of this inert gas is straightened by the gas flow-guide cylinder 17, and the inert gas is passed between the heat shielding member 18 and the melt surface of the raw material melt 4, and discharged from a gas outlet duct.

And, in the single crystal-producing apparatus 20 of the present invention, as the gas flow-guide cylinder 17 which is disposed so as to surround the silicon single crystal 3, the gas flow-guide cylinder 17 provided with the quartz member 19 containing bubbles thereinside is used. The quartz member 19 containing bubbles may be provided in a cylindrical shape inside the gas flow-guide cylinder, or a flat-plate quartz member may be disposed so as to cover the inside of the gas flow-guide cylinder.

Here, the bubble-containing quartz member of the present invention is generally called as an opaque quartz glass. The opaque quartz glass is of high purity and excellent in heat resistance and such, and is more excellent in insulating property for heat ray or infrared ray than that of a transparent quartz glass. By placing such an opaque quartz glass inside the gas flow-guide cylinder, during the pulling of the silicon single crystal, radiation from the heating heater or the raw material melt is insulated and the heat-retaining property in the gas flow-guide cylinder is enhanced, and the crystal temperature gradient G along the pulling axis direction in the vicinity of the solid-liquid interface is controlled to be uniform along the radial direction of the single crystal. Thereby, it becomes possible to produce a silicon single crystal in which a desired defect region is distributed uniformly in a plane by controlling F/G to be a constant value.

It is preferable that in such a quartz member 19 containing bubbles, a density of the bubbles of diameters of 30 to 120 µm is in the range of 5 × 10⁹ number/cm³ to 1 × 10⁶ number/cm³. For example, in the case of a transparent quartz glass of a thickness of 4 mm, linear transmittance of infrared ray of wavelength of 1 to 2.5 µm is approximately 90%, and in the case of the bubble-containing quartz member (opaque quartz glass), infrared ray or heat ray is reflected by the fine bubbles in the glass, and therefore, for example, in the case of the quartz member of a thickness of 4 mm having the above-described bubble density, linear transmittance of infrared ray of wavelength of 1 to 2.5 µm becomes 0.5% or less. Therefore, by the quartz member having such a bubble density, radiation in an infrared region of long wavelength from the heating heater or the raw material melt can be more effectively insulated and heat-retaining property in the gas flow-guide cylinder can be improved, and by controlling F/G constantly to be a predetermined value with a high pulling rate F, it becomes possible to produce a silicon single crystal in which a desired defect region is distributed uniformly in a plane, and particularly, there can be obtained heat-insulating property being sufficient for enlarging the permissible width for controlling the pulling rate being capable of producing a silicon single crystal having a defect-free region. Moreover, even under a high temperature, it becomes difficult to cause deformation of the quartz member due to expansion of the bubbles. In particular, if the bubble density is 2 ×10⁵ number/cm³ or more, it is more effective for insulating radiation of infrared ray of wavelength of 2 µm or more.

Moreover, it is preferable that the quartz member 19 containing bubbles that is provided inside the gas flow-guide cylinder 17 has an occupied rate of 20% or more with respect to a surface area inside the gas flow-guide cylinder 17, and has a wall thickness of 3 mm or more. By such a quartz member, radiant heat from the heating heater or the silicon melt can be more effectively insulated. In addition, by considering workability, economical efficiency, own weight of the quartz member, and so forth, it is preferable that the wall thickness of the quartz member containing bubbles is 50 mm or less.

The quartz member 19 containing bubbles that is provided inside the gas flow-guide cylinder 17 is exposed to a high temperature during the single crystal growth, and therefore is required to have excellent heat resistance. Therefore, it is preferable that the quartz member 19 containing bubbles has a logarithmic viscosity of 10 poise to 14 poise in 1250°C, by considering a reason for its production, too. Thereby, the quartz member can be prevented from being deformed due to a high temperature, and the quartz member can have a long operating life. In this case, the surface of the quartz member is subjected to a baking finish by a high-temperature burner, and the quartz member whose surface is finished to be shiny and flat is suitably used.

Furthermore, it is preferable that in such a quartz member 19 provided inside the gas flow-guide cylinder 17, an average impurity concentration of Fe and Cu in a surface layer region from a surface of the quartz member to a depth of 10 µm is less than 1 ppm, and an average impurity concentration of Fe and Cu in a region of a depth of more than 10 µm from the surface of the quartz member is lower than that of the surface layer region. When the quartz member provided inside the gas flow-guide cylinder has the average impurity concentrations of Fe and Cu being in the above-described ranges, contamination with impurities of Fe and Cu from the gas flow-guide cylinder can be certainly prevented, and silicon single crystal of high quality having no impurity contamination can be stably produced.

In addition, the quartz member 19 containing bubbles is not only placed inside the lower part of the gas flow-guide cylinder 17 as shown in Fig. 1, but also, for example as shown in Fig. 2(a), it is possible that the quartz member 19 containing bubbles is provided inside the gas flow-guide cylinder 17 and further a heat insulating material 22 made of a carbon felt or the like covered with a heat insulating material cover 21 at the lower part inside this quartz member 19. By this manner, the heat-retaining property in the gas flow-guide cylinder is more enhanced and additionally contamination with Fe or Cu from the heat insulating material can be prevented. Moreover, it is possible that as shown in Fig. 2(b), as well as inside the gas flow-guide cylinder 17, the lower end or the outside thereof is also covered with the quartz member 19 containing bubbles, or that as shown in Fig. 2(c), the gas flow-guide cylinder 17 itself is made of the same material as the quartz member containing bubbles. Also, by these manners, the heat-retaining property in the gas flow-guide cylinder can be enhanced, and furthermore, the contamination due to Fe or Cu can be prevented.

Next, a single crystal-producing method of the present invention for growing a silicon single crystal by using the above-described single crystal-producing apparatus 20 of the present invention will be explained.

In the case in which a silicon single crystal is grown by CZ method by using the above-described single crystal-producing apparatus 20, first, a seed crystal 16 is held in a seed holder 15, and high-purity polycrystalline raw material of silicon is contained in the quartz crucible 5, and heated with a heating heater 7 to the melting point (approximately 1420°C) or more and melted. And, along with introducing the inert gas such as Ar in the chamber from the gas inlet duct 10, a wire 14 is winded off, and thereby the tip end of the seed crystal 16 is contacted with or immersed in the approximately central part of the surface of the raw material melt 4. Then, with rotating the crucibles 5, 6, the seed crystal 16 is calmly pulled with rotating the wire 14, and thereby, for example, after forming a neck, a corn portion is formed by enlarging the diameter to a desired diameter, and then a silicon single crystal 3 having a straight body with an approximately column shape can be grown.

In the present invention, when the silicon single crystal 3 is grown in this manner, heat radiation from the heater for heating the silicon melt or the silicon melt can be insulated and heat-retaining property in the gas flow-guide cylinder can be improved because such a gas flow-guide cylinder 17 inside which the quartz member 19 containing bubbles is provided as described above is disposed so as to surround the silicon single crystal 3. Thereby, the crystal temperature gradient G along the pulling axis direction in the vicinity of the solid-liquid interface in the pulling of the single crystal can be controlled to be uniform along the radial direction of the single crystal, and particularly a silicon single crystal in which a defect-free region is distributed uniformly in a plane can be produced at a high pulling rate. Furthermore, the permissible width for controlling the pulling rate in order to produce a defect-free region can be enhanced.

Specifically explaining, in the case in which the silicon single crystal is grown so that the defect region becomes N region in the entire plane along the radial direction, the pulling rate F is set according to the production environment in which the single crystal is produced (for example, HZ of the single crystal-producing apparatus, and so forth) so that the straight body of the silicon single crystal can be grown to be N region. In this case, in the present invention, because the temperature gradient G in a plane is uniform, the pulling rate F can be set to the maximum in the range of being capable of growing the silicon single crystal to be N region. That is, because the temperature gradient G in a plane is uniform, if the pulling rate F is set to the maximum, the defect distribution is not out of N region.

Furthermore, in the present invention, because the quartz member containing bubbles is provided inside the gas flow-guide cylinder, contamination with impurities of Fe and Cu from the gas flow-guide cylinder being caused during the growth of the single crystal can be effectively prevented and the silicon single crystals of high quality can be stably produced with high yield. In particular, if the average impurity concentration of Fe and Cu of the quartz member provided inside the gas flow-guide cylinder is very low as described above, the grown silicon single crystal can be certainly prevented from the impurity concentration.

In each of the wafers obtained from the silicon single crystal produced by the above-described method, impurity contamination is not caused so that, for example, Fe concentration in 10% of the periphery of the wafer is 1 × 10¹⁰ atoms/cm³ or less and Cu concentration is 1 × 10¹¹ atoms/cm³ or less, and it becomes a low-defect wafer in which the entire plane of the wafer is N region.

Hereinafter, Examples of the present invention will be exemplified specifically. However, the present invention is not limited thereto.

### (Example 1)

By using the apparatus 20 for pulling a single crystal as shown in Fig. 1, 150 kg of raw material polycrystalline silicon was charged in the quartz crucible 5 with a diameter of 24 inch (600 mm), and a silicon single crystal with a diameter of 8 inch (200 mm), an orientation of <100>, and an oxygen concentration of 22 to 23 ppma (ASTM'79), was pulled by CZ method. Inside the lower end of the gas flow-guide cylinder 17 made of isotropic graphite that was suspended from the ceiling of the pulling chamber 2 so as to surround the pulled single crystal along the single crystal growth direction, there was provided the bubble-containing quartz member 19 having bubbles of diameters of 30 to 120 µm, the bubble density of 2 ×10⁵ number/cm³ to 3 × 10⁵ number/cm³, the logarithmic viscosity of 12 poise in 1250°C, the occupied rate of 90% with respect to the inside surface area, the wall thickness of 10 mm, and a height of 150 mm. In addition, the density of the bubbles contained in the quartz member was obtained by, observing the quartz member with a size of 30 mm ×10 mm × 0.3 mm by a microscope, counting the number of the bubbles of diameters of 30 to 120 µm, and converting this number into the number per 1 cm³. Moreover, the distance from the melt surface to the lower end of the gas flow-guide cylinder was set to 60 mm.

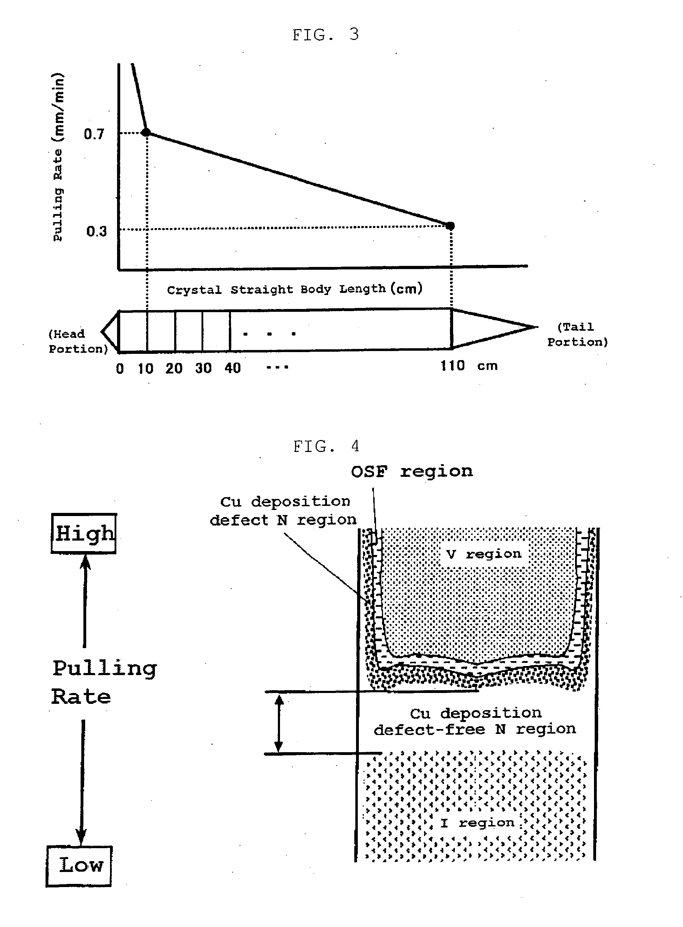

As the pulling rate condition of the single crystal, as shown in Fig. 3, the pulling rate from 10 cm of the straight body of the single crystal to 110 cm thereof was controlled to be reduced gradually from the crystal head portion to the tail portion in the range of 0.7 mm/min to 0.3 mm/min.

Next, after wafers were sliced from the sites by 10 cm along the growth axis direction of the single crystal grown in the above-described manner, surface grinding and polishing were performed and thereby the sample wafers for examination were produced and the following examinations of crystal quality characteristics were performed.

### (1) Investigation of FPD (V region) and LEP (I region)

After each of the sample wafers was subjected to Secco etching for 30 min without stirring, the wafer plane was observed by a microscope, and it was confirmed whether each of FPD and LEP exists or not.

### (2) Investigation of OSF region

After each of the sample wafers was subjected to the heat treatment under a wet oxygen atmosphere at 1100 °C for 100 min, the wafer plane was observed by a microscope, and it was confirmed whether OSF region exists or not.

### (3) Investigation of Defects by Cu Deposition Treatment

On the surface of each of the sample wafers, an oxide film was formed, and then Cu deposition treatment was performed, and it was confirmed whether an oxide film defect exists or not. The condition of the treatment is as follows.
Oxide Film: 25 nm,
Electric Field Intensity: 6 MV/cm,
Voltage Applying Time: 5 min.

### (4) Measurement of Fe Concentration

The average Fe concentration in the bulk of 10% of the periphery of each of the sample wafers, namely, the wafer peripheral portion within 20 mm along the radial direction from the outermost periphery of the wafer, was measured by SPV method (Surface Photo-voltage method). In addition, the measurement condition of the Fe concentration is as follows.
FeB Dissociation Temperature: 210 °C,
Dissociation Time: 3 min,
Measurement Apparatus: CMS-IIIA manufactured by SDI Inc..

### (5) Measurement of Cu Concentration

By analyzing the entirety of the dissolved solution of each of the sample wafers with acid steam by an inductively coupled plasma mass spectrometry (ICP-MS), the average Cu concentration in the bulk of 10% of the wafer periphery (the wafer peripheral portion within 20 mm along the radial direction from the outermost periphery of the wafer) was measured.

As a result of performing the above-described examinations with respect to the silicon single crystal produced in Example 1, the view of the crystal defect distribution as shown in Fig. 4 was obtained, and the pulling rate in the border of Cu deposition defect N region/ Cu deposition defect-free N region was 0.51 mm/min, and the pulling rate in the border of Cu deposition defect-free N region/ I region was 0.48 mm/min.

The average Fe concentration in the wafer peripheral portion within 20 mm along the radial direction from the outermost periphery of each of the sample wafers was 3.5 to 7.6 × 10⁹ atoms/cm³ as shown in Fig. 6. Moreover, the average Cu concentration was 1 × 10¹¹ atoms/cm³ or less.

### (Example 2)

The same apparatus for pulling a single crystal as Example 1 was used except using the gas flow-guide cylinder provided with the bubble-containing quartz member 19 having bubbles of diameters of 30 to 120 µm, the bubble density of 5 × 10⁴ number/cm³, the logarithmic viscosity of 10 poise in 1250°C, the occupied rate of 90% with respect to the inside surface area, the wall thickness of 10 mm, and a height of 150 mm, inside the lower end of the gas flow-guide cylinder 17 placed in the apparatus 20 for pulling a single crystal. And, a silicon single crystal with a diameter of 8 inch (200 mm), an orientation of <100>, and an oxygen concentration of 22 to 23 ppma (ASTM'79), was pulled by CZ method. In addition, as the condition of the pulling rate when the single crystal was pulled, in the same manner as Example 1, the pulling rate from 10 cm of the straight body of the single crystal to 110 cm thereof was controlled to be reduced gradually from the crystal head portion to the tail portion in the range of 0.7 mm/min to 0.3 mm/min.

As a result of performing the above-described examinations with respect to the silicon single crystal produced in Example 2, the approximately same view of the crystal defect distribution as Fig. 4 of Example 1 was obtained, and the pulling rate in the border of Cu deposition defect N region/ Cu deposition defect-free N region was 0.51 mm/min, and the pulling rate in the border of Cu deposition defect-free N region/ I region was 0.49 mm/min.

The average Fe concentration in the wafer peripheral portion within 20 mm along the radial direction from the outermost periphery of each of the sample wafers was 4.5 to 8.1 × 10⁹ atoms/cm³ as shown in Fig. 6. Moreover, the average Cu concentration was 1 × 10¹¹ atoms/cm³ or less.

### (Comparative example 1)

The same apparatus for pulling a single crystal as Example 1 was used except using the gas flow-guide cylinder provided with the heat insulating material made of carbon felt having an occupied rate of 90% with respect to the inside surface area, a wall thickness of 10 mm, and a height of 100 mm, inside the lower end of the gas flow-guide cylinder placed in the apparatus for pulling a single crystal. And, a silicon single crystal with a diameter of 8 inch (200 mm), an orientation of <100>, and an oxygen concentration of 22 to 23 ppma (ASTM'79), was pulled by CZ method. In addition, as the condition of the pulling rate when the single crystal was pulled, in the same manner as Example 1, the pulling rate from 10 cm of the straight body of the single crystal to 110 cm thereof was controlled to be reduced gradually from the crystal head portion to the tail portion in the range of 0.7 mm/min to 0.3 mm/min.

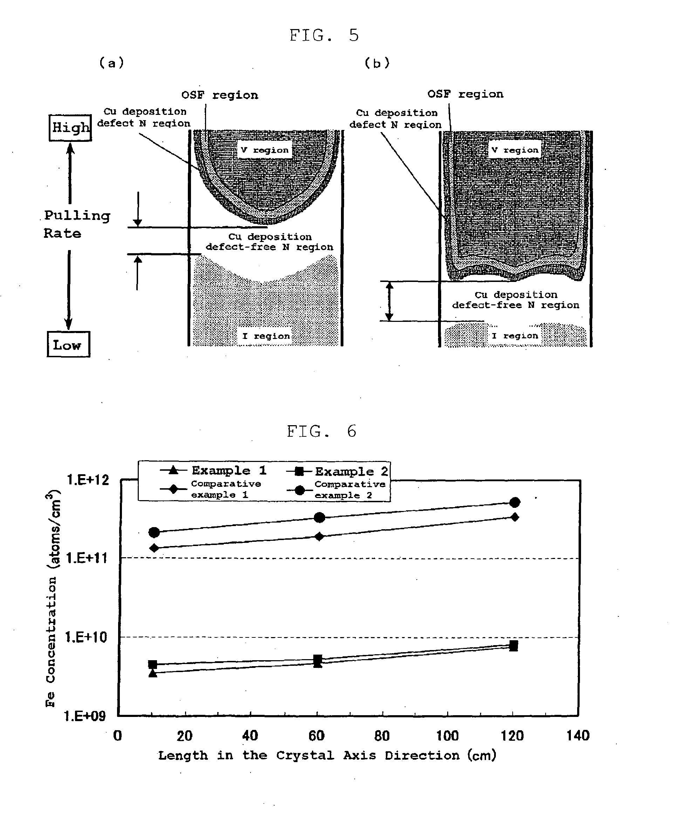

As a result of performing the above-described examinations with respect to the silicon single crystal produced in Comparative example 1, the view of the crystal defect distribution as shown in Fig. 5(a) was obtained, and the pulling rate in the border of Cu deposition defect N region/ Cu deposition defect-free N region was 0.51 mm/min, and the pulling rate in the border of Cu deposition defect-free N region/ I region was 0.49 mm/min.

The average Fe concentration in the wafer peripheral portion within 20 mm along the radial direction from the outermost periphery of each of the sample wafers was 1.3 to 3.4 × 10¹¹ atoms/cm³ as shown in Fig. 6. Moreover, the average Cu concentration was 1 to 2 × 10¹² atoms/cm³.

### (Comparative example 2)

The same apparatus for pulling a single crystal as Example 1 was used except using the gas flow-guide cylinder provided with the heat insulating material made of carbon felt having an occupied rate of 90% with respect to the inside surface area, a wall thickness of 10 mm, and a height of 100 mm, inside the lower end of the gas flow-guide cylinder placed in the apparatus for pulling a single crystal, and except setting the distance from the melt surface to the lower end of the gas flow-guide cylinder to be 70 mm. And, a silicon single crystal with a diameter of 8 inch (200 mm), an orientation of <100>, and an oxygen concentration of 22 to 23 ppma (ASTM'79), was pulled by CZ method. In addition, as the condition of the pulling rate when the single crystal was pulled, in the same manner as Example 1, the pulling rate from 10 cm of the straight body of the single crystal to 110 cm thereof was controlled to be reduced gradually from the crystal head portion to the tail portion in the range of 0.7 mm/min to 0.3 mm/min.

As a result of performing the above-described examinations with respect to the silicon single crystal produced in Comparative example 2, the view of the crystal defect distribution as shown in Fig. 5(b) was obtained, and the pulling rate in the border of Cu deposition defect N region/ Cu deposition defect-free N region was 0.47 mm/min, and the pulling rate in the border of Cu deposition defect-free N region/ I region was 0.44 mm/min.

The average Fe concentration in the wafer peripheral portion within 20 mm along the radial direction from the outermost periphery of each of the sample wafers was 2.1 to 5.2 × 10¹¹ atoms/cm³ as shown in Fig. 6. Moreover, the average Cu concentration was 1 to 2 × 10¹² atoms/cm³.

The silicon single crystals of Examples 1 and 2 were produced by the single crystal-producing apparatus using the gas flow-guide cylinder inside which the quartz member containing bubbles was disposed, and therefore, the heat-retaining property in the gas flow-guide cylinder was improved, and the temperature gradient along the pulling axis direction in the vicinity of the solid-liquid interface was possible to be controlled to be uniform along the radial direction, and therefore, the defect distribution being uniform in a plane was obtained. Moreover, because the quartz member was used, the contamination with Fe and Cu from the gas flow-guide cylinder 17 could be prevented, and Fe and Cu concentration contained in the single crystal became low. In particular, in the silicon single crystal of Example 1, by using the quartz member having the higher bubble density, the heat-retaining property in the gas flow-guide cylinder was further improved, and therefore, the control width of the pulling rate being capable of obtaining the Cu deposition defect-free N region was enlarged in the side of the low rate.

On the other hand, the silicon single crystal of Comparative example 1 was produced by the single crystal-producing apparatus using the gas flow-guide cylinder inside which the heat insulating material made of carbon felt was disposed, and thereby, it was possible to improve the heat-retaining property in the gas flow-guide cylinder, and therefore, the pulling rate being capable of obtaining Cu deposition defect-free N region was high. However, the temperature gradient along the pulling axis direction in the vicinity of the solid-liquid interface was impossible to be controlled to be uniform along the radial direction, and therefore, the defect distribution being uniform in a plane was not obtained. Therefore, the control width of the pulling rate became narrower than that of Example 1. Moreover, contamination with Fe and Cu originated from the heat insulating material made of carbon felt was caused, and the Fe and Cu concentration in the crystal became high. In the silicon single crystal of Comparative example 2, because the distance between the melt and the lower end of the gas flow-guide cylinder was enlarged, the defect distribution being uniform in a plane was obtained, and the control width of the pulling rate being capable of obtaining the Cu deposition defect-free N region was enlarged. However, the pulling rate being capable of obtaining the Cu deposition defect-free N region became low. Moreover, because the heat insulating material made of carbon felt was used, the Fe and Cu concentration in the crystal became high.

The present invention is not limited to the above-described embodiments. The above-described embodiments are mere examples, and those having the substantially same constitution as that described in the appended claims and providing the similar action and advantages are included in the scope of the present invention.

## Claims

1. An apparatus for producing a single crystal by which a silicon single crystal is grown by Czochralski method, comprising, at least, a gas flow-guide cylinder which is disposed so as to surround the silicon single crystal in a chamber for growing the single crystal in order to straighten flow of a gas introduced into the chamber, and a quartz member containing bubbles that is provided inside the gas flow-guide cylinder.

2. The apparatus for producing a single crystal according to Claim 1, wherein a density of the bubbles in the quartz member containing bubbles that is provided inside the gas flow-guide cylinder is in a range of 5 × 10⁴ number/cm³ to 1 × 10⁶ number/cm³.

3. The apparatus for producing a single crystal according to Claim 1 or 2, wherein the quartz member containing bubbles that is provided inside the gas flow-guide cylinder has an occupied rate of 20% or more with respect to a surface area inside the gas flow-guide cylinder, and has a wall thickness of 3 mm to 50 mm.

4. The apparatus for producing a single crystal according to any one of Claims 1 to 3, wherein the quartz member containing bubbles that is provided inside the gas flow-guide cylinder has a logarithmic viscosity of 10 poise to 14 poise in 1250°C.

5. The apparatus for producing a single crystal according to any one of Claims 1 to 4, wherein in the quartz member containing bubbles that is provided inside the gas flow-guide cylinder, an average impurity concentration of Fe and Cu in a surface layer region from a surface of the quartz member to a depth of 10 µm is less than 1 ppm, and an average impurity concentration of Fe and Cu in a region of a depth of more than 10 µm from the surface of the quartz member is lower than that of the surface layer region.

6. A method for producing a single crystal, comprising growing a silicon single crystal by using the apparatus for producing a single crystal according to any one of Claims 1 to 5.
